# DEMANDE DE BREVET EUROPEEN

(11) **EP 3 217 547 A1**
(43) Date de publication de la demande: **13.09.2017**
(21) Numéro de dépôt: 17160241.0
(22) Date de dépôt: 10.03.2017
(51) Int. Cl.: H03K 3/038, H03K 19/094

(54) **INVERSEUR A TROIS ETATS, BASCULE D A VERROUILLAGE ET BISTABLE MAITRE-ESCLAVE COMPRENANT DES TFET**

(30) Priorité: 11.03.2016 FR 1652056
(71) Demandeur: Commissariat à l'énergie atomique et aux énergies alternatives, 75015 Paris (FR)
(72) Inventeur: GUPTA, Navneet, 38000 GRENOBLE (FR); MAKOSIEJ, Adam, 38000 GRENOBLE (FR); ANGHEL, Costin, 92170 VANVES (FR); AMARA, Amara, 92330 SCEAUX (FR)
(74) Mandataire: Brevalex

(57) **Abrégé**

Inverseur à trois états (108, 112) comprenant :
- un premier n-TFET (118, 128) et un premier p-TFET (116, 126), le drain du n-TFET étant connecté au drain du p-TFET et à une sortie de l'inverseur à trois états, les grilles du n-TFET et du p-TFET étant connectées à une entrée de l'inverseur à trois états ;
- un circuit de commande apte à appliquer une première tension de commande sur la source du n-TFET et une seconde tension de commande sur la source du p-TFET, les première et seconde tensions de commande étant positives ;
et, lorsque l'inverseur à trois états est destiné à fonctionner comme un inverseur, la première tension de commande est inférieure à la seconde tension de commande, et lorsque l'inverseur à trois états est destiné à être dans un état haute impédance, la première tension de commande est supérieure à la seconde tension de commande.

## Description

### DOMAINE TECHNIQUE ET ART ANTERIEUR

L'invention concerne un inverseur à trois états, une bascule D à verrouillage et un bistable maître-esclave comprenant des TFET, qui peuvent répondre aux exigences d'applications à ultrabasse consommation ULP (pour « Ultra-Low-Power »), comme l'IdO (Internet des Objets), tout en maintenant une performance élevée.

Les tendances précédentes de conception de système sur puce (SoC pour « System on Chip ») étaient focalisées sur l'amélioration de la performance du système sans s'intéresser à la consommation d'énergie. Une approche standard d'amélioration de performance consistait à utiliser des coeurs plus grands et des processeurs multicoeurs. La mise à l'échelle de la technologie a également aidé à améliorer la performance. Cependant, en raison d'une fuite accrue avec la mise à l'échelle de la technologie, la consommation d'énergie est devenue un paramètre important de la spécification de projet.

Le développement de solutions écoénergétiques est encore plus crucial pour le monde de l'IoD qui présente une exigence toujours croissante de durée de vie de batterie plus longue tout en maintenant la performance. En raison de l'importance croissante du marché de l'IoD, de nombreux rapports ont été orientés vers une optimisation d'énergie de veille pour des systèmes avec de courtes durées d'activité. Des efforts ont été faits pour optimiser la consommation d'énergie dynamique à la fois au niveau du système et du circuit à l'aide de diverses techniques de circuit, comme la mise à l'échelle dynamique de la tension et de la fréquence (DVFS), le portillonage de puissance, et une zone de sacrifice pour fournir moins de fuite tout en maintenant une performance suffisante. La DVFS est une technique particulièrement importante dans le monde de l'IoD en raison de l'exigence de fréquence de fonctionnement selon le mode, allant de quelques kHz à des dizaines de MHz. La réduction d'énergie est prise en considération à toutes les phases de la conception incluant les niveaux de circuit, de technologie et d'architecture système. Par exemple, pour permettre une réduction de fuite en mode d'attente, des cellules classiques à portillonage de puissance ont été proposées.

Des technologies autres que CMOS sont également examinées afin de réduire l'énergie tout en maintenant la performance.

Le TFET (pour « Tunnel Field-Effect Transistor ») est l'une des alternatives prometteuses au CMOS. Des architectures multicoeurs avec des coeurs hétérogènes CMOS/TFET à la place d'un coeur CMOS sont proposées pour réduire la consommation d'énergie. Une conception de puce de multiprocesseurTFET-CMOS hybride (CMP) qui utilise des coeurs CMOS pour la performance élevée et des coeurs TFET pour l'énergie faible a été proposée dans le document V. Saripalli et al., « An Energy-Efficient Heterogeneous CMP Based on Hybrid TFET-CMOS Cores », dans Design Automation Conference (DAC), 2011, pages 729 à 734. On sait par ailleurs utiliser la technique DVFS compatible avec un produit à retard d'énergie avec des coeurs CMOS/TFET hétérogènes pour améliorer le rendement énergétique. L'optimisation d'énergie se fait à tous les niveaux, de l'architecture système aux composants individuels.

Les bistables, ou bascules, sont des composants cruciaux dans toute conception SoC, notamment pour les systèmes à logique numérique et microprocesseur où les bistables sont utilisés en tant que registres pipelines, piles de registre et mémoires tampons. Même pour un microprocesseur à performance moyenne, plus de mille bistables sont nécessaires pour l'implémentation. Pour le moment, la plupart des conceptions sont à base de CMOS, par conséquent, les bistables destinés aux MOSFET sont bien explorés en vue d'optimisations de consommation d'énergie et de performance.

Le document M. COTTER et al., « Evaluation of tunnel FET-based flip-flop designs for low power, high performance application », ISQED, 2013, divulgue un bistable TFET à performance élevée et basse tension. Les conceptions de ces bistables sont similaires aux bistables CMOS. Cependant, la fuite signalée est supérieure à celles obtenues dans des implémentations CMOS et FinFET. Cela est dû principalement au fait que les dispositifs TFET utilisés dans le bistable divulgué sont optimisés en termes de vitesse et fournissent un courant I_{ON} supérieur aux dépens d'une fuite accrue.

De façon plus générale, les différentes conceptions d'inverseur à trois états, de bascule D à verrouillage et de bistable maître-esclave proposées dans la littérature présentent l'inconvénient de nécessiter de nombreux transistors.

### EXPOSE DE L'INVENTION

L'objectif de la présente invention est de proposer un nouvel inverseur à trois états, une nouvelle bascule D à verrouillage, ou verrou D, et un nouveau bistable maître-esclave, ou bascule maître-esclave, nécessitant moins de transistors, et permettant également d'obtenir de nouvelles architectures de bascule D à verrouillage et de bistable dans lesquelles les caractéristiques de TFET sont utilisées de façon optimale, c'est-à-dire avec moins de fuites tout en étant compatibles avec des applications à basse consommation et sans pénaliser la vitesse de fonctionnement du bistable.

Ainsi, l'invention propose un inverseur à trois états comprenant au moins :
- un premier n-TFET et un premier p-TFET, le drain du premier n-TFET étant connecté au drain du premier p-TFET et à une sortie de l'inverseur à trois états, les grilles du premier n-TFET et du premier p-TFET étant connectées à une entrée de l'inverseur à trois états ;
- un circuit de commande apte à appliquer une première tension de commande sur la source du premier n-TFET et une seconde tension de commande sur la source du premier p-TFET, les valeurs des première et seconde tensions de commande étant positives ou nulles ;
et dans lequel le circuit de commande est configuré pour commander les valeurs des première et seconde tensions de commande de sorte que, lorsque l'inverseur à trois états est destiné à fonctionner comme un inverseur, la valeur de la première tension de commande est inférieure à la valeur de la seconde tension de commande, et lorsque l'inverseur à trois états est destiné à être dans un état haute impédance, la valeur de la première tension de commande est supérieure à la valeur de la seconde tension de commande.

Comparé à un inverseur à trois états CMOS classique nécessitant quatre transistors MOS, ce nouvel inverseur à trois états ne nécessite que deux transistors TFET. Ainsi, ce nouvel inverseur à trois états nécessite une aire plus petite de semi-conducteur qu'un inverseur à trois états réalisé avec davantage de transistors, ce qui permet de réduire le coût de réalisation de l'inverseur à trois états.

De plus, cet inverseur à trois états est implémenté sans empilement de dispositifs, ce qui se traduit par une amélioration significative de la vitesse à des tensions de fonctionnement basses.

La première tension de commande peut être un premier signal d'horloge oscillant entre un état haut et un état bas, et la seconde tension de commande peut être un second signal d'horloge qui est complémentaire du premier signal d'horloge. Ainsi, lorsque la valeur du premier signal d'horloge correspond à un état haut, la valeur du second signal d'horloge correspond à un état bas, et lorsque la valeur du premier signal d'horloge correspond à un état bas, la valeur du second signal d'horloge correspond à un état haut.

Dans cet inverseur à trois états, lorsque celui-ci est destiné à être dans un état haute impédance, la valeur de la première tension de commande est supérieure à la valeur de la seconde tension de commande se sorte à isoler la sortie de l'inverseur à trois états vis-à-vis de l'entrée de l'inverseur à trois états. Cette isolation est obtenue grâce à la polarisation inverse des TFETs dans cette configuration conduisant à une tension grille - source nulle ou négative pour le n-TFET et une tension grille - source nulle ou positive pour le p-TFET. En l'absence d'ambipolarité, les conditions ci-dessus peuvent bloquer complètement les TFETs.
leading to negative or zero gate-to-source voltage for the n-type TFET and positive or zero gate-to-source voltage for the p-type TFET. In the absence of ambipolarity, the above-mentioned conditions may completely block the devices.

Selon une définition alternative, l'invention propose un inverseur à trois états comprenant au moins :
- un premier n-TFET et un premier p-TFET, le drain du premier n-TFET étant connecté au drain du premier p-TFET et à une sortie de l'inverseur à trois états, les grilles du premier n-TFET et du premier p-TFET étant connectées à une entrée de l'inverseur à trois états ;
- un circuit de commande apte à appliquer une première tension de commande sur la source du premier n-TFET et une seconde tension de commande sur la source du premier p-TFET, les valeurs des première et seconde tensions de commande étant positives ou nulles,
et dans lequel le circuit de commande est apte à appliquer, dans une première configuration, la première tension de commande de valeur inférieure à celle de la seconde tension de commande de sorte à faire fonctionner l'inverseur à trois états dans un mode inverseur dans lequel le signal de sortie délivré a une valeur complémentaire de celle du signal reçu en entrée, et à appliquer, dans une deuxième configuration, la première tension de commande de valeur supérieure à celle de la seconde tension de commande de sorte à faire fonctionner l'inverseur à trois états dans un mode haute impédance.

Il est également proposé un procédé de commande d'un inverseur à trois états comprenant au moins un premier n-TFET et un premier p-TFET, le drain du premier n-TFET étant connecté au drain du premier p-TFET et à une sortie de l'inverseur à trois états, les grilles du premier n-TFET et du premier p-TFET étant connectées à une entrée de l'inverseur à trois états, dans lequel :
- lorsque l'inverseur à trois états est destiné à fonctionner dans un mode inverseur, une première tension de commande est appliquée sur la source du premier n-TFET et une seconde tension de commande est appliquée sur la source du premier p-TFET, les valeurs des première et seconde tensions de commande étant positives ou nulles et telles que la valeur de la première tension de commande soit inférieure à la valeur de la seconde tension de commande ;
- lorsque l'inverseur à trois états est destiné à fonctionner dans un mode haute impédance, la première tension de commande appliquée sur la source du premier n-TFET et la seconde tension de commande appliquée sur la source du premier p-TFET ont des valeurs positives ou nulles et telles que la valeur de la première tension de commande soit supérieure à la valeur de la seconde tension de commande.

L'invention concerne également une bascule D à verrouillage comprenant au moins :
- un inverseur à trois états tel que divulgué ci-dessus, l'entrée de l'inverseur à trois états correspondant à une entrée de la bascule D à verrouillage ;
- une bascule à verrouillage comprenant un deuxième n-TFET, un deuxième p-TFET et un noeud de stockage formé par la connexion de la source du deuxième n-TFET à la source du deuxième p-TFET, une sortie de la bascule D à verrouillage étant connectée au noeud de stockage de la bascule à verrouillage ;
dans lequel le circuit de commande est apte à appliquer :
- la première tension de commande sur la grille de l'un des deuxièmes n-TFET et p-TFET, et la seconde tension de commande sur la grille de l'autre des deuxièmes n-TFET et p-TFET ;
- une première tension d'alimentation sur la source du deuxième p-TFET et une seconde tension d'alimentation sur la source du deuxième n-TFET;
et dans lequel les première et seconde tensions d'alimentation sont telles que les deuxièmes n-TFET et p-TFET sont polarisés en inverse dans un état dans lequel un courant de conduction peut être obtenu par un effet de tunnel bande à bande dans les deuxièmes n-TFET et p-TFET. Le courant de conduction est obtenu lorsque les deuxièmes TFET ont une tension V_{DS} non nulle.

Dans une telle bascule D à verrouillage, la fonction de mémorisation est réalisée par une bascule à verrouillage, ou verrou, comprenant deux TFET et utilisant une propriété de résistance différentielle négative NDR (pour « Negative Differential Resistance ») des TFET en polarisation inverse. Ainsi, la puissance de fuite est considérablement réduite comparée à une autre architecture de bascule D à verrouillage, et l'énergie nécessaire pour la bascule D à verrouillage est considérablement réduite comparée aux bascules D à verrouillage de l'art antérieur.

De plus, au vu du petit nombre de transistors utilisés dans cette bascule D à verrouillage, la consommation d'énergie dynamique de la bascule D à verrouillage est inférieure à celle d'autres bascules D à verrouillage réalisées avec d'autres architectures.

Il est également proposé un procédé de commande d'une bascule D à verrouillage comprenant au moins :
- un inverseur à trois états tel que divulgué ci-dessus, l'entrée de l'inverseur à trois états correspondant à une entrée de la bascule D à verrouillage ;
- une bascule à verrouillage comprenant un deuxième n-TFET, un deuxième p-TFET et un noeud de stockage formé par la connexion de la source du deuxième n-TFET à la source du deuxième p-TFET, une sortie de la bascule D à verrouillage étant connectée au noeud de stockage de la bascule à verrouillage ;
et dans lequel :
- une première tension de commande est appliquée sur la source du premier n-TFET et sur la grille de l'un des deuxièmes n-TFET et p-TFET,
- une deuxième tension de commande est appliquée sur la source du premier p-TFET et sur la grille de l'autre des deuxièmes n-TFET et p-TFET ;
- une première tension d'alimentation est appliquée sur la source du deuxième p-TFET ;
- une seconde tension d'alimentation est appliquée sur la source du deuxième n-TFET ;
et dans lequel les première et seconde tensions d'alimentation sont telles que les deuxièmes n-TFET et p-TFET sont polarisés en inverse dans un état dans lequel un courant de conduction peut être obtenu par un effet de tunnel bande à bande dans les deuxièmes n-TFET et p-TFET.

La différence entre les valeurs des première et seconde tensions d'alimentation peut être inférieure à 0,6 V, par exemple entre environ 0,3 V et 0,6 V. Cependant, ces valeurs peuvent se trouver hors de la plage 0,3 V à 0,6 V, ces valeurs dépendant des caractéristiques intrinsèques des TFET ainsi que des conditions de fonctionnement requises de la bascule D à verrouillage.

L'invention propose également un bistable maître-esclave, ou bascule maître-esclave, comprenant au moins des première et seconde bascules D à verrouillage telles que décrites ci-dessus, dans lequel :
- la sortie de la première bascule D à verrouillage est connectée à l'entrée de la seconde bascule D à verrouillage ;
- l'entrée de la première bascule D à verrouillage correspond à une entrée du bistable maître-esclave ;
- une sortie du bistable maître-esclave est connectée à la sortie de la seconde bascule D à verrouillage ;
- la valeur de la première tension de commande appliquée dans la première bascule D à verrouillage est égale à la valeur de la seconde tension de commande appliquée dans la seconde bascule D à verrouillage ; et
- la valeur de la seconde tension de commande appliquée dans la première bascule D à verrouillage est égale à la valeur de la première tension de commande appliquée dans la seconde bascule D à verrouillage.

Ainsi, l'invention propose une conception de bistable ultracompacte utilisant des TFET compatibles avec des applications ULP avec une exigence de durée de vie de batterie longue tout en fournissant une bonne performance.

Comme expliqué ci-dessus pour la bascule D à verrouillage, un tel bistable maître-esclave utilise une propriété NDR (résistance différentielle négative) des TFET en polarisation inverse, conduisant à une réduction importante de la puissance de fuite par rapport aux autres architectures de bistable, ainsi qu'à une réduction de l'énergie requise. En effet, à tout moment donné, la moitié des TFET dans le bistable maître-esclave de l'invention sont en condition de polarisation inverse, ce qui se traduit par un courant de fuite extrêmement faible (< 3fA/bistable).

De plus, le petit nombre de transistors utilisés dans ce bistable maître-esclave (réduit d'au moins 50 % en comparaison aux implémentations CMOS et FinFET) permet d'obtenir une consommation d'énergie dynamique faible. Le nombre inférieur de transistors conduit à une C_{GS} faible des TFET et à une aire réduite de semi-conducteur requise pour ce bistable maître-esclave, réduisant ainsi le coût du bistable.

Il est également proposé un procédé de commande d'un bistable maître-esclave, ou bascule maître-esclave, comprenant au moins des première et seconde bascules D à verrouillage telles que décrites ci-dessus, dans lequel :
- la sortie de la première bascule D à verrouillage est connectée à l'entrée de la seconde bascule D à verrouillage ;
- l'entrée de la première bascule D à verrouillage correspond à une entrée du bistable maître-esclave ;
- une sortie du bistable maître-esclave est connectée à la sortie de la seconde bascule D à verrouillage ;
- la valeur de la première tension de commande appliquée dans la première bascule D à verrouillage est égale à la valeur de la seconde tension de commande appliquée dans la seconde bascule D à verrouillage ; et
- la valeur de la seconde tension de commande appliquée dans la première bascule D à verrouillage est égale à la valeur de la première tension de commande appliquée dans la seconde bascule D à verrouillage.

Ce bistable, ainsi que la bascule D à verrouillage de l'invention, sont compatibles avec d'autres composants CMOS (pilote, unité de commande, etc.), permettant l'implémentation de coeurs hétérogènes au sein d'un seul processus CMOS utilisant à la fois des dispositifs TFET et CMOS.

De plus, sans la rétroaction d'implémentation de bascule à verrouillage ni empilement de dispositifs, la vitesse de fonctionnement de ce bistable maître-esclave est comparable ou dépasse la vitesse d'une implémentation FinFET haute performance, notamment pour le fonctionnement faible tension où les retards d'inverseur sont importants.

Le bistable maître-esclave peut être tel que :
- la première tension de commande appliquée dans la première bascule D à verrouillage et la seconde tension de commande appliquée dans la seconde bascule D à verrouillage est un premier signal d'horloge oscillant entre un état haut et un état bas ; et
- la seconde tension de commande appliquée dans la première bascule D à verrouillage et la première tension de commande appliquée dans la seconde bascule D à verrouillage est un second signal d'horloge qui est complémentaire du premier signal d'horloge.

Ainsi, lorsque la valeur du premier signal d'horloge correspond à un état haut, la valeur du second signal d'horloge correspond à un état bas, et lorsque la valeur du premier signal d'horloge correspond à un état bas, la valeur du second signal d'horloge correspond à un état haut. La valeur de l'état haut peut correspondre à la valeur de la première tension d'alimentation et la valeur de l'état bas peut correspondre à la valeur de la seconde tension d'alimentation.

Le premiersignal d'horloge peut être utilisé pourgénérer le second signal d'horloge, par exemple en utilisant un inverseur.

Le bistable maître-esclave peut en outre comprendre un premier inverseur comportant au moins un troisième n-TFET et un troisième p-TFET, le drain dudit troisième n-TFET étant connecté au drain dudit troisième p-TFET et à une sortie du premier inverseur, les grilles dudit troisième n-TFET et dudit troisième p-TFET étant connectées à une entrée du premier inverseur qui est connectée à la sortie de la seconde bascule D à verrouillage, et le circuit de commande peut être apte à appliquer la première tension d'alimentation sur la source dudit troisième p-TFET et la seconde tension d'alimentation sur la source dudit troisième n-TFET. Dans une telle configuration, le bistable maître-esclave comprend uniquement 12 TFET (avec un autre inverseur comprenant deux TFET générant le second signal d'horloge à partir du premier signal d'horloge) et la sortie du bistable maître-esclave correspond à la sortie du premier inverseur. Le premier inverseur permet d'isoler les bascules à mémoire interne d'une sortance extérieure. Dans cette configuration, la valeur de la sortie du bistable maître-esclave et la valeur stockée dans le bistable, ou la valeur de la sortie du bistable maître-esclave et la valeur précédemment appliquée sur l'entrée du bistable maître-esclave sont inversées.

Le bistable maître-esclave peut en outre comprendre un second inverseur comportant au moins un quatrième n-TFET et un quatrième p-TFET, le drain dudit quatrième n-TFET étant connecté au drain dudit quatrième p-TFET et à une sortie du second inverseur, les grilles dudit quatrième n-TFET et dudit quatrième p-TFET étant connectées à une entrée du second inverseur qui est connectée à la sortie du premier inverseur, et le circuit de commande peut être apte à appliquer la première tension d'alimentation sur la source dudit quatrième p-TFET et la seconde tension d'alimentation sur la source dudit quatrième n-TFET. Dans cette configuration, le bistable maître-esclave comprend uniquement 14 TFET (avec l'autre inverseur comprenant deux TFET générant le second signal d'horloge à partir du premier signal d'horloge) et la sortie du bistable maître-esclave correspond à la sortie du second inverseur, c'est-à-dire que la valeur de la sortie du bistable maître-esclave correspond à la valeur précédemment appliquée sur l'entrée du bistable maître-esclave.

Dans chacune des première et seconde bascules D à verrouillage, la première tension de commande peut être appliquée sur la grille du deuxième n-TFET, et la seconde tension de commande peut être appliquée sur la grille du deuxième p-TFET. Dans ce cas, le bistable maître-esclave correspond à un bistable à déclenchement sur le front positif.

Dans chacune des première et seconde bascules D à verrouillage, la première tension de commande peut être appliquée sur la grille du deuxième p-TFET et la seconde tension de commande peut être appliquée sur la grille du deuxième n-TFET. Dans ce cas, le bistable maître-esclave correspond à un bistable à déclenchement sur le front négatif.

### BREVE DESCRIPTION DES DESSINS

D'autres caractéristiques et avantages de l'invention ressortiront plus clairement à la lecture de la description ci-après et des exemples de modes de réalisation fournis uniquement à titre indicatif et non limitatif, en référence aux dessins annexés sur lesquels :
- la figure 1 représente la caractéristique I_{D}(V_{DS}) d'un n-TFET polarisé en direct ;
- la figure 2 représente la caractéristique I_{D}(V_{DS}) d'un n-TFET polarisé en inverse, pour différentes valeurs de V_{GS} ;
- les figures 3a à 3c représentent symboliquement les différents comportements d'un TFET polarisé en inverse ;
- la figure 4 représente des capacités grille à source (C_{GS}) et grille à drain (C_{GD}) de TFET selon V_{DS}, obtenues pour différentes valeurs de V_{GS} ;
- la figure 5 représente un bistable maître-esclave selon un mode de réalisation particulier de l'invention ;
- la figure 6 représente un inverseur TFET permettant d'obtenir un signal d'horloge complémentaire utilisé dans le bistable selon l'invention ;
- la figure 7 représente la caractéristique I_{D}(V_{Q0}) avec une polarisation inverse V_{DS} pour le n-TFET et le p-TFET d'une bascule à verrouillage du bistable selon l'invention ;
- la figure 8 représente un pilote de sortie facultatif pour le bistable selon l'invention ;
- la figure 9 représente des formes d'onde de signaux du bistable selon l'invention ;
- la figure 10 représente la puissance de fuite obtenue avec le bistable selon l'invention et avec d'autres bistables de l'art antérieur ;
- la figure 11 représente la consommation d'énergie dynamique du bistable selon l'invention et d'autres bistables de l'art antérieur ;
- la figure 12 représente le temps de configuration obtenu pour le bistable selon l'invention et pour d'autres bistables de l'art antérieur ;
- la figure 13 représente le délai de propagation horloge à sortie obtenu pour le bistable selon l'invention et pour d'autres bistables de l'art antérieur ;
- la figure 14 représente la fréquence de fonctionnement maximale obtenue pour le bistable selon l'invention et pour les autres bistables de l'art antérieur ;
- la figure 15 représente un inverseur à trois états selon un mode de réalisation particulier de l'invention ;
- la figure 16 représente une bascule D à verrouillage selon un mode de réalisation particulier de l'invention ;
- la figure 17 représente un bistable maître-esclave selon un mode de réalisation particulier de l'invention ;
- la figure 18 représente des formes d'onde de signaux de l'inverseur à trois états selon l'invention.

Des parties identiques, similaires ou équivalentes des figures différentes décrites ci-dessous ont les mêmes références numériques à des fins de clarté entre les figures.

Les différentes parties représentées sur les figures ne sont pas nécessairement à l'échelle, afin de rendre les figures plus compréhensibles.

Les différentes possibilités (alternatives et modes de réalisation) ne doivent pas être comprises comme s'excluant mutuellement l'une l'autre et peuvent ainsi être combinées les unes aux autres.

### DESCRIPTION DETAILLEE DE MODES DE REALISATION PARTICULIERS

Les TFET sont des jonctions p-i-n polarisées en inverse qui fonctionnent par effet tunnel, où le potentiel électrostatique de la région intrinsèque est commandé par une électrode de grille. Les TFET utilisés dans l'inverseur à trois états, la bascule D à verrouillage et le bistable décrits ci-dessous sont étalonnés et conçus à partir de données similaires à celles divulguées dans le document C. ANGHEL et al., « 30-nm Tunnel FET with improved performance and reduced ambipolar current », IEEE Transactions on Electron Devices, 2011.

Par exemple :
- les TFET sont construits à l'aide d'espaceurs à faible permittivité diélectrique (Low-k) (SiO₂) et d'un diélectrique de grille à forte permittivité diélectrique (High-k) (HfO₂) ;
- les longueurs de grille et d'espaceurs sont de 30 nm chacune ;
- l'épaisseur physique du diélectrique de grille est de 3 nm ;
- l'épaisseur du film de silicium (tSi) utilisé pour former les régions de source, de drain et de canal est de 4 nm.

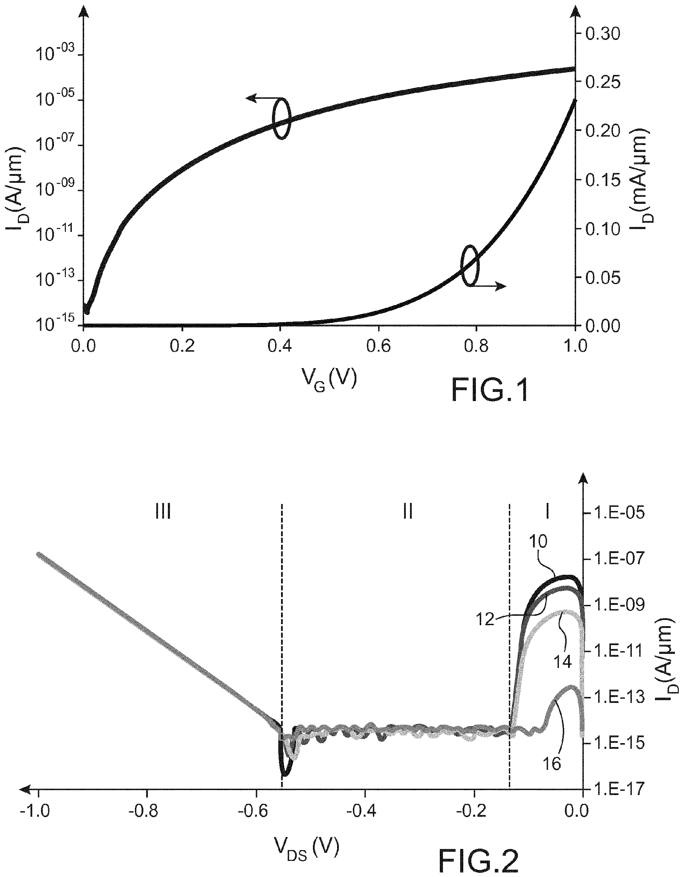

Les TFET utilisés dans l'inverseur à trois états, la bascule D à verrouillage et le bistable décrits ci-dessous ont une caractéristique I_{D}(V_{G}) dans une condition de polarisation en direct comme représentée sur la figure 1. Sur cette figure, la caractéristique correspond à l'une d'un n-TFET.

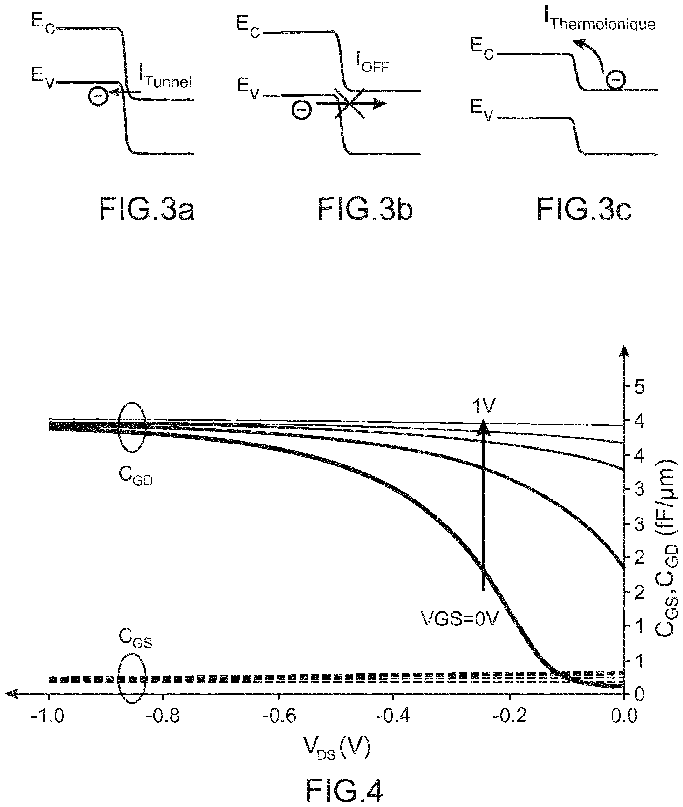

La figure 2 représente la caractéristique I_{D}(V_{DS}) d'un n-TFET polarisé en inverse pour différentes valeurs de V_{GS} : V_{GS} = 1 V pour la courbe 10, V_{GS} = 0,75 V pour la courbe 12, V_{GS} = 0,5 V pour la courbe 14 et V_{GS} = 0,25 V pour la courbe 16. Pour cette caractéristique, trois régions correspondant à trois comportements différents du TFET peuvent se distinguer comme suit :
- la région I, qui est dénommée la « bosse », dans laquelle un courant de conduction I_{Tunnel} est obtenu dans le TFET par effet tunnel bande à bande (le mécanisme d'injection de charge correspondant à l'effet tunnel bande à bande est symboliquement représenté sur la figure 3a) ;
- la région II, qui est dénommée la « région de courant plat », dans laquelle le courant de conduction obtenu dans la région I n'est plus obtenu en raison du non-chevauchement des bandes (représenté symboliquement sur la figure 3b) ;
- la région III, qui est dénommée l'« état passant p-i-n », dans laquelle le mécanisme d'injection de charge est dominé par l'émission thermoionique au-dessus de la barrière, créant un courant dénommé I_{Thermoionique} représenté symboliquement sur la figure 3c. Dans cette région III, le TFET a un comportement similaire à un court-circuit.

Pour la région III, la caractéristique de sortie polarisée en inverse est dite « unidirectionnelle » en raison du fait que la grille perd le contrôle sur le n-TFET pour des tensions drains à source négative élevées et perd le contrôle sur le p-TFET pour des tensions drains à source positive élevées.

Dans l'inverseur à trois états, la bascule D à verrouillage et le bistable décrits ici, les TFET ne sont pas polariser en inverse avec une tension V_{DS} négative élevée pour le n-TFET (et une tension V_{DS} positive élevée pour le p-TFET) afin d'éviter des courants de fuite élevés obtenus dans la région III, c'est-à-dire lorsque les TFET ont un comportement d'« état passant p-i-n ».

Les capacités grille à source (C_{GS}) et grille à drain (C_{GD}) des TFET sont représentées sur la figure 4. La C_{GS} pour les TFET est toujours basse et a une faible dépendance à la tension de grille. La capacité de grille totale est dominée par la C_{GD}.

Pour les simulations de circuit suivantes, le p-TFET et le n-TFET sont tous deux modélisés à l'aide de tables de référence. Les caractéristiques de courant continu et de capacité sont toutes deux implémentées sous forme de tables I_{D}(V_{GS},V_{DS}), C_{GS}(V_{GS},V_{DS}), C_{GD}(V_{GS},V_{DS}).

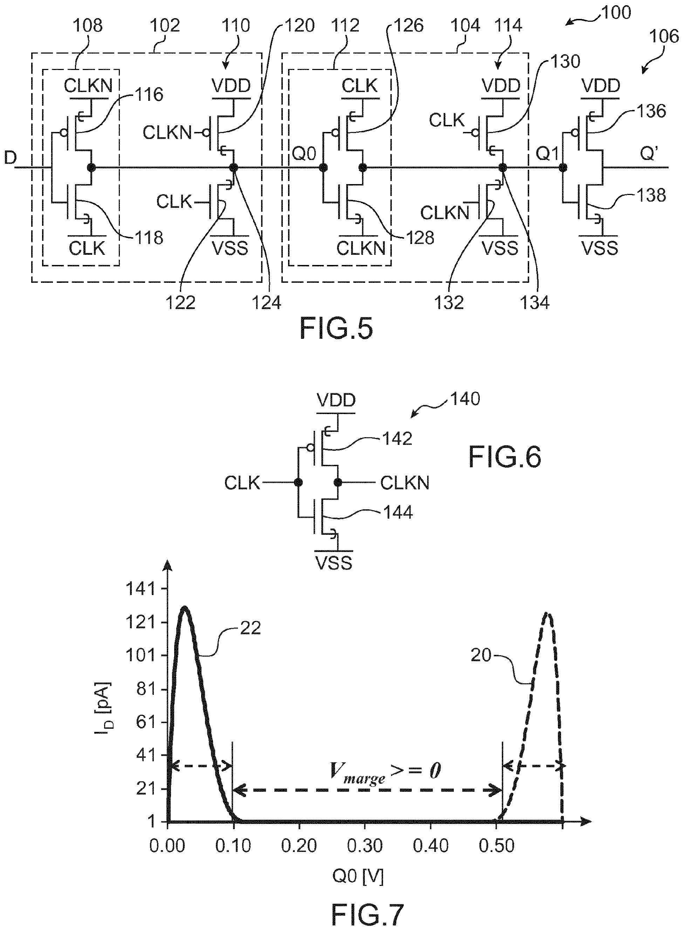

Un bistable maître-esclave 100 selon un mode de réalisation particulier est représenté sur la figure 5.

Le bistable 100 comprend une première bascule D à verrouillage 102 et une seconde bascule D à verrouillage 104. Dans le mode de réalisation particulier décrit ici, le bistable 100 comprend également un premier inverseur 106 servant de pilote de sortie. Dans une variante de mode de réalisation, le bistable 100 peut ne pas comprendre cet inverseur 106.

La première bascule D à verrouillage 102 comprend un premier inverseur à trois états 108 et une première bascule à verrouillage 110. La seconde bascule D à verrouillage 104 comprend un second inverseur à trois états 112 et une seconde bascule à verrouillage 114.

Le premier inverseur à trois états 108 comprend un premier p-TFET 116 et un premier n-TFET 118. Le drain du premier p-TFET 116 est connecté au drain du premier n-TFET 118 et à la sortie du premier inverseur à trois états 108. Un signal d'horloge CLK, correspondant à une première tension de commande, est appliqué sur la source du premier n-TFET 118, et un signal d'horloge complémentaire CLKN (c'est-à-dire ayant une valeur d'état haut, par exemple entre environ 0,3 V et 0,6 V, lorsque le signal CLK a une valeur d'état bas, par exemple autour de 0 V, et ayant une valeur d'état bas lorsque le signal CLK a une valeur d'état haut), correspondant à un second signal de commande, est appliqué sur la source du premier p-TFET 116. Une entrée D du bistable 100 est connectée aux grilles des premiers p-TFET 116 et n-TFET 118.

Surtoutes les figures de ce document, le symbole utilisé pour représenter un TFET comporte un crochet localisé sur la source du TFET. Le crochet peut être représenté différemment de ceux représentés ici, selon la convention choisie. En particulier, le sens du crochet peut être inversé.

La première bascule à verrouillage 110 comprend un deuxième p-TFET 120 et un deuxième n-TFET 122. La source du deuxième p-TFET 120 est connectée à la source du deuxième n-TFET 122, lesquelles forment un noeud de stockage 124 de la première bascule à verrouillage 110. Le potentiel électrique du noeud de stockage 124 est dénommé Q0. La sortie du premier inverseur à trois états 108 est connectée au noeud de stockage 124. Une première tension d'alimentation V_{DD}, par exemple entre environ 0,3 V et 0,6 V, est appliquée sur le drain du deuxième p-TFET 120 et une seconde tension d'alimentation Vss, par exemple autour de 0 V et correspondant à la masse, est appliquée sur le drain du deuxième n-TFET 122. Le signal d'horloge complémentaire CLKN est appliqué sur la grille du deuxième p-TFET 120 et le signal d'horloge CLK est appliqué sur la grille du deuxième n-TFET 122.

Avantageusement, la valeur d'état haut de CLK est égale à la valeur de la tension V_{DD}. Dans ce cas, un nombre moins important de tensions d'alimentation est requis.

Le second inverseur à trois états 112 comprend des éléments similaires à ceux du premier inverseur à trois états 108, c'est-à-dire un premier p-TFET 126 et un premier n-TFET 128. Le drain du premier p-TFET 126 est connecté au drain du premier n-TFET 128, lesquels forment la sortie du second inverseur à trois états 112. Le signal d'horloge CLK est appliqué sur la source du premier p-TFET 126 et le signal d'horloge complémentaire CLKN est appliqué sur la source du premier n-TFET 128. Le potentiel électrique Q0 est appliqué sur les grilles des premiers p-TFET 126 et n-TFET 128.

La seconde bascule à verrouillage 114 comprend des éléments similaires à ceux de la première bascule à verrouillage 110, c'est-à-dire un deuxième p-TFET 130 et un deuxième n-TFET 132. La source du deuxième p-TFET 130 est connectée à la source du deuxième n-TFET 132, lesquelles forment un noeud de stockage 134 de la seconde bascule à verrouillage 114. Le potentiel électrique du noeud de stockage 134 est dénommé Q1. La sortie du second inverseur à trois états 112 est connectée au noeud de stockage 134.

La première tension d'alimentation V_{DD} est appliquée sur le drain du deuxième p-TFET 130 et la seconde tension d'alimentation Vss est appliquée sur le drain du deuxième n-TFET 132. Le signal d'horloge CLK est appliqué sur la grille du deuxième p-TFET 130 et le signal d'horloge complémentaire CLKN est appliqué sur la grille du deuxième n-TFET 132.

L'inverseur 106 a des composants et une structure similaires à ceux des inverseurs trois états 108, 112. Il comprend un troisième p-TFET 136 et un troisième n-TFET 138. Le drain du troisième p-TFET 136 est connecté au drain du troisième n-TFET 138, lesquels forment la sortie de l'inverseur 106 qui correspond à la sortie du bistable maître-esclave 100. La première tension d'alimentation V_{DD} est appliquée sur la source du troisième p-TFET 136 et la seconde tension d'alimentation Vss est appliquée sur la source du troisième n-TFET 138. Le potentiel électrique Q1 est appliqué sur les grilles des troisièmes p-TFET 136 et n-TFET 138. Le comportement de l'inverseur 106 est tel que la valeur du potentiel électrique obtenu à la sortie de l'inverseur 106, dénommé Q' (correspondant à la valeur du potentiel électrique sur les drains des troisièmes TFET 136, 138) est complémentaire du potentiel Q1 appliqué à l'entrée de l'inverseur 106.

Le signal d'horloge complémentaire CLKN peut être obtenu à l'aide d'un autre inverseur 140 comme le montre la figure 6. Cet inverseur 140 comprend un p-TFET 142 et un n-TFET 144 agencés et connectés de la même façon que les troisièmes TFET 136, 138 de l'inverseur 106.

Lorsque CLK a une valeur correspondant à l'état bas, les premiers n-TFET 118 et p-TFET 116 fonctionnent comme un inverseur et la sortie du premier inverseur à trois états 108 est à un état complémentaire de celui de l'entrée D. Lorsque CLK a une valeur correspondant à un état haut, le premier inverseur à trois états 108 est dans un état haute impédance car les premiers n-TFET 118 et p-TFET 116 sont polarisés en inverse. De la même façon, le second inverseur à trois états 112 est dans un état haute impédance lorsque CLK a une valeur correspondant à l'état bas et fonctionne comme un inverseur lorsque CLK a une valeur correspondant à l'état haut.

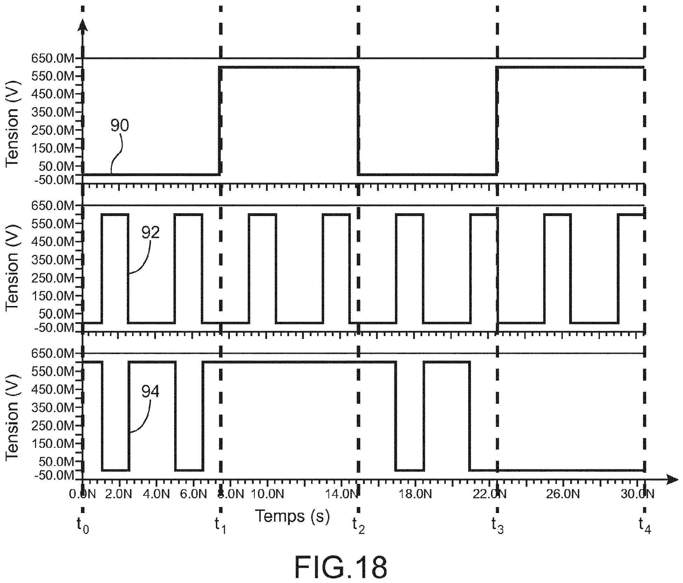

La figure 18 représente les signaux obtenus au sein du premier inverseur à trois états 108. La référence 90 désigne le signal d'horloge CLK (avec CLKN correspondant au signal inverse de CLK), la référence 92 désigne le signal appliqué sur l'entrée D, et la référence 94 désigne le signal obtenu à la sortie de l'inverseur à trois états 108. Sur cette figure, entre les instants t₀ et t₁ et entre les instants t₂ et t₃, l'inverseur à trois états 108 fonctionne comme un inverseur. Entre les instants t₁ et t₂ et entre les instants t₃ et t₄, l'inverseur à trois états 108 est dans un état haute impédance, c'est-à-dire un état dans lequel la sortie est isolée de l'entrée, la valeur du signal obtenu en sortie étant décorrélée de celle du signal appliqué en entrée.

La première bascule D à verrouillage 102 forme une bascule maître du bistable 100 et la seconde bascule D à verrouillage 104 forme une bascule esclave du bistable 100.

Ces bascules maître et esclave sont implémentées à l'aide de la propriété de résistance différentielle négative NDR des TFET qui est expliquée dans le document US 2011/0299326 A1.

La caractéristique I_{D}(V_{Q0}) avec une polarisation inverse V_{DS} pour le p-TFET 120 (courbe 20) et le n-TFET 122 (courbe 22) de la première bascule à verrouillage 110 est représentée sur la figure 7, avec V_{DD}-V_{SS} = 0,6 V (par exemple obtenu avec Vss = 0 V et V_{DD} = 0,6 V, ou avec V_{SS} = -0,3 V et V_{DD} = 0,3 V). Cette caractéristique montre que les n-TFET 122 et p-TFET 120 polarisés en inverse avec de telles tensions d'alimentation ont un comportement similaire à un comportement de bascule à verrouillage, à la condition que l'alimentation totale de la bascule à verrouillage (V_{DD}-V_{SD}) soit inférieure au point critique où le courant de TFET devient indépendant de la tension de grille (correspondant à la région III représentée sur la figure 2 où les mécanismes d'injection de charge dans le TFET sont dominés par l'émission thermoionique au-dessus de la barrière). Dans l'exemple décrit ici, ce point est égal à environ 0,6 V. Ainsi, si V_{SS} = 0 V, V_{DD} est choisie ≤ 0,6 V. La valeur de l'état haut de CLK est maintenue élevée afin d'obtenir un pilotage de grille suffisant pour générer une bosse de courant pour les deux TFET 120, 122.

Puisque le deuxième n-TFET 122 est conducteur lorsque V_{Q0} est proche de Vss et que le deuxième p-TFET 120 est conducteur lorsque V_{Q0} est proche de V_{DD}, une valeur '0', ou une valeur d'état bas, est stockée dans la première bascule à verrouillage 110 sur le deuxième n-TFET 122, le deuxième p-TFET 120 étant dans ce cas à l'état bloqué, et une valeur '1', ou une valeur d'état haut, est stockée dans la première bascule à verrouillage 110 sur le deuxième p-TFET 120, le deuxième n-TFET 122 étant dans ce cas à l'état bloqué. Pour une tension d'alimentation totale (V_{DD}-V_{SD}) de 0,6 V, le noeud de stockage 124 est déchargé à travers le deuxième n-TFET 122 pour 0 < Q0 < 100 mV (plage correspondant à la largeur de la bosse, région I, de la caractéristique I_{D}(V_{DS}) 22 du n-TFET 122) jusqu'à ce que Q0 = Vss, c'est-à-dire ici Q0 = 0 V. De la même façon, le Q0 est chargé à la valeur de V_{DD} par le p-TFET 120 pour 0,5 V < Q0 < 0,6 V (plage correspondant à la largeur de la bosse, région I, de la caractéristique I_{D}(V_{DS}) 20 du p-TFET 120).

La distance entre les deux bosses de la caractéristique I_{D}(V_{DS}) des deuxièmes TFET 120, 122 est dénommée V_{marge} et correspond à la plage de tension pour laquelle la première bascule à verrouillage 110 est métastable. Ici, les caractéristiques des deuxièmes TFET 120, 122 et les valeurs des V_{DD} et V_{SS} sont telles que V_{marge} ≥ 0.

La valeur de crête de courant obtenue au sommet des bosses de la caractéristique I_{D}(V_{DS}) des deuxièmes TFET 120, 122 varie avec la tension de grille appliquée (CLK et CLKN) mais la largeur de la bosse reste plutôt indépendante de la tension de grille, comme le montre la figure 2.

Le comportement de la seconde bascule à verrouillage 114 est similaire à celui expliqué ci-dessus pour la première bascule à verrouillage 110, sauf en ce qui concerne les tensions de grille appliquées qui sont complémentaires de celles appliquées sur les grilles des deuxièmes TFET 120, 122 de la première bascule à verrouillage 110.

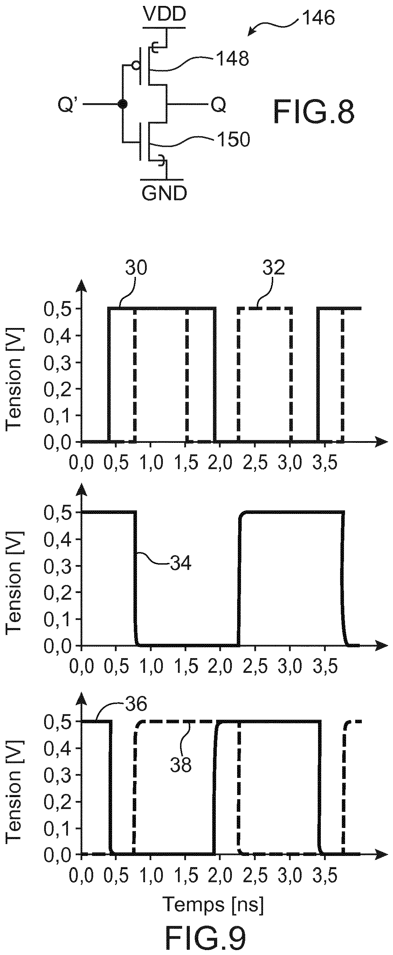

L'inverseur 106 est utilisé pour isoler la bascule à mémoire interne d'une sortance extérieure. Puisque la valeur Q' obtenue à la sortie du bistable maître-esclave 100 est complémentaire de celle de Q1 (en raison du comportement de l'inverseur 106), le bistable maître-esclave peut comprendre un second inverseur 146 ayant une entrée sur laquelle Q' est appliqué (c'est-à-dire ayant son entrée connectée à la sortie de l'inverseur 106) et produisant en sortie une valeur Q correspondant à celle de Q1, comme le montre la figure 8. Ce second inverseur 146 comprend un quatrième p-TFET 148 et un quatrième n-TFET 150 agencés et connectés de la même façon que les troisièmes TFET 136, 138 de l'inverseur 106. La sortie du bistable maître-esclave 100 correspond ainsi à la sortie du second inverseur 146.

Le comportement du bistable 100 et de ses noeuds internes pour des transitions de données et d'horloge est représenté sur la figure 9. Le signal D porte la référence 30, le signal CLK porte la référence 32, le potentiel Q' porte la référence 34, le potentiel Q0 porte la référence 36 et le potentiel Q1 porte la référence 38.

Concernant le comportement du bistable 100, lorsque CLK est bas, D est complété par le premier inverseur à trois états 108. La première bascule à verrouillage 110 (maître) et le second inverseur à trois états 112 sur Q1 sont dans l'état haute impédance. La valeur Q1 est préservée par la seconde bascule à verrouillage 114 et les sorties (Q' ou Q) sont pilotées par les inverseurs 106, 146. Lorsque CLK est haut, le premier inverseur à trois états 108 est dans l'état haute impédance et la première bascule à verrouillage 110 préserve la valeur sur Q0 et pilote Q1 à l'aide du second inverseur à trois états 112. Pendant cette période, la seconde bascule à verrouillage 114 est à l'état haute impédance.

Le bistable 100 représenté sur la figure 5 fonctionne comme un bistable à déclenchement sur le front positif. En échangeant les connexions CLK et CLKN par des bascules à verrouillage maître et esclave 110, 114, le bistable obtenu fonctionne comme un bistable à déclenchement sur le front négatif.

A des fins de simulation, une sortance constante de 4 inverseurs a été prise en considération. Le bistable maître-esclave 100 est simulé à l'aide des modèles de table expliqués ci-dessus. A des fins de comparaison, un bistable maître-esclave industriel classique est implémenté en CMOS 28 nm, FinFET 22 nm à faible énergie de veille (LSTP pour « Low Standby Power ») et FinFET 22 nm haute performance (HP) à l'aide de modèles PTM. Des mesures pour différents paramètres, tels que le temps de configuration (« setup time »), l'énergie et le délai horloge à Q sont réalisées avec des contraintes similaires pour toutes les conceptions. L'analyse est faite pour une plage de tensions (V_{DD}-V_{SS}) de 0,3 V à 0,6 V, qui est appropriée pour la conception proposée et ses cas d'utilisation.

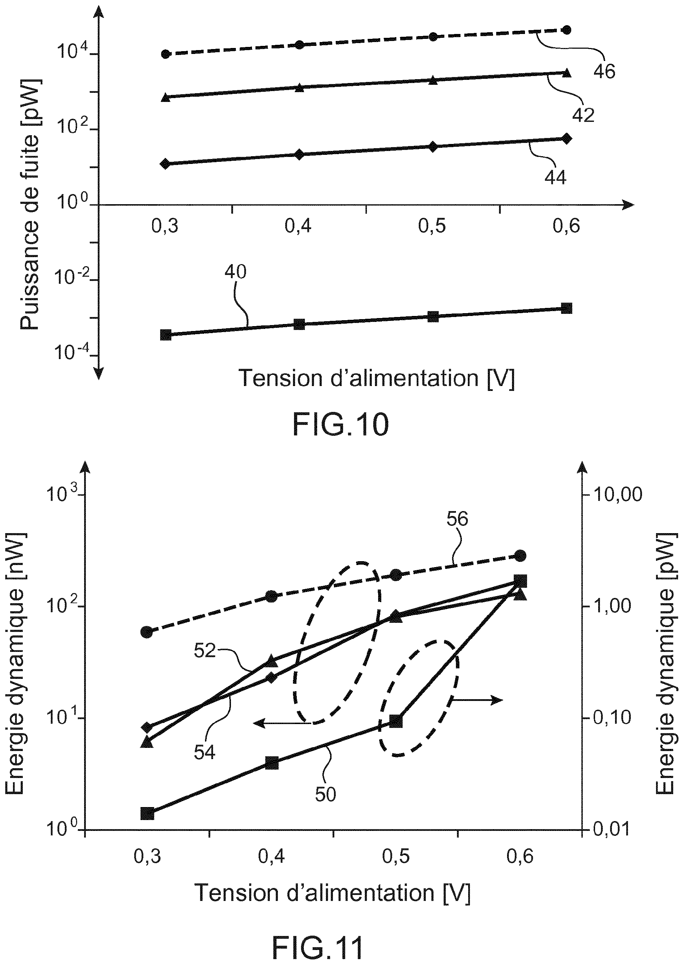

La figure 10 représente la consommation d'énergie de fuite pour le bistable maître-esclave 100 (courbe 40), le bistable CMOS (courbe 42), le bistable FinFET LSTP (courbe 44) et le bistable FinFET HP (courbe 46). Cette figure montre que la consommation d'énergie statique du bistable maître-esclave 100 est réduite de 4 à 7 décades en comparaison aux conceptions à CMOS et FinFET.

La consommation d'énergie dynamique pour les mêmes conceptions de bistable est représentée sur la figure 11 (courbe 50 pour le bistable maître-esclave 100, courbe 52 pour le bistable CMOS, courbe 54 pour le bistable FinFET LSTP et courbe 56 pour le bistable FinFET HP). La capacité de noeuds internes de bistable pour le bistable maître-esclave 100 est bien moins élevée que dans les bistables CMOS et FinFET en raison du nombre inférieur de transistors. Ainsi, la consommation d'énergie dynamique pour le bistable maître-esclave 100 est mieux de 3 à 5 décades que celle de conceptions à CMOS et FinFET.

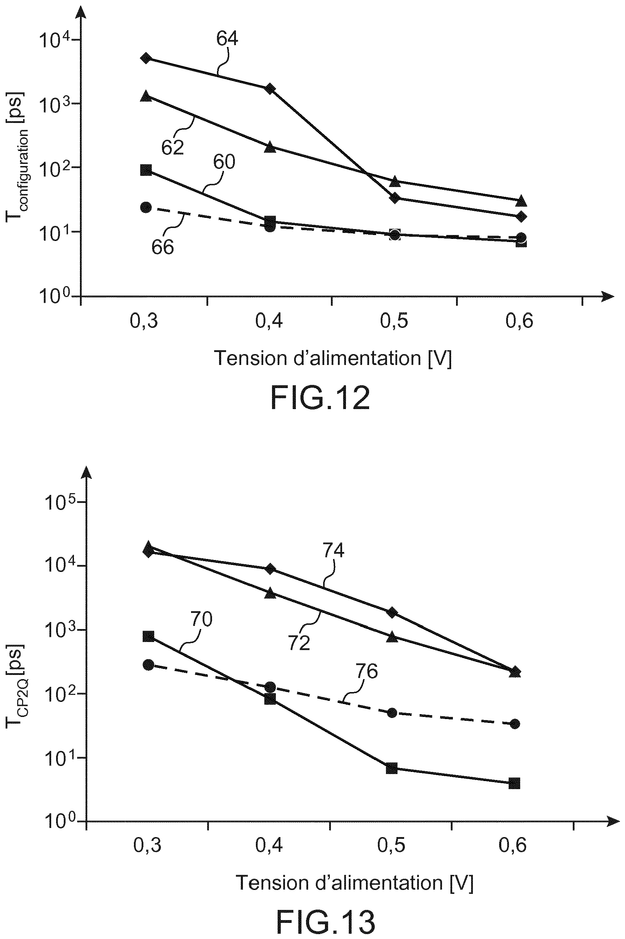

La figure 12 représente l'exigence de temps de configuration pour les mêmes conceptions de bistable (courbe 60 pour le bistable maître-esclave 100, courbe 62 pour le bistable CMOS, courbe 64 pour le bistable FinFET LSTP et courbe 66 pour le bistable FinFET HP). Il convient de noter que le bistable maître-esclave 100 est plus rapide que les bistables CMOS et FinFET-LSTP pour la plage de tensions d'alimentation de 0,3 V à 0,6 V. Cependant, l'exigence de configuration est quasi similaire à celle du bistable FinFET HP qui est globalement le plus rapide mais également le plus énergivore.

A une alimentation de 0,3 V, le temps de configuration de la conception proposée est de 14,6x et 56x inférieur en comparaison aux conceptions à CMOS et FinFET-LSTP, respectivement. Cependant, le temps de configuration est toujours de 3,75x supérieur à celui du bistable FinFET-HP à une tension d'alimentation de 0,3 V.

La figure 13 représente le délai de propagation horloge à sortie (T_{CP2Q}) pour les mêmes conceptions de bistable (courbe 70 pour le bistable maître-esclave 100, courbe 72 pour le bistable CMOS, courbe 74 pour le bistable FinFET LSTP et courbe 76 pour le bistable FinFET HP). En raison du nombre inférieur d'éléments de retard dans le trajet horloge à sortie et de la capacité inférieure, le T_{CP2Q} est réduit de façon significative pour le bistable 100. Le T_{CP2Q} est de 20x à 58x inférieur à des conceptions à CMOS et FinFET-LSTP, respectivement. Pour un fonctionnement en dessous de 0,4 V, le T_{CP2Q} est 8x meilleur pour le bistable FinFET-HP aux dépens d'une consommation d'énergie de fuite de 10⁷x supérieure en comparaison au bistable TFET 100.

Le temps de maintien pour le bistable maître-esclave 100 et pour l'autre bistable maître-esclave décrit ci-dessus est dominé par le délai de l'inverseur sur CLK pour générer CLKN. Par conséquent, il est similaire pour toutes les conceptions implémentées.

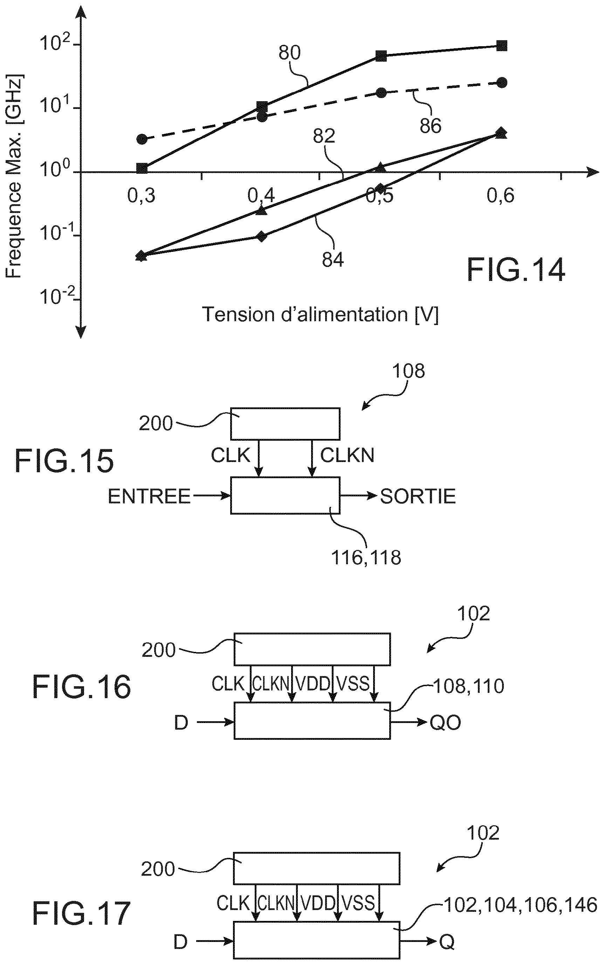

La vitesse de fonctionnement maximale pour le bistable est limitée par le temps de configuration et le délai de propagation horloge à sortie. La figure 14 représente la limite théorique de fréquence de fonctionnement, définie comme 1/(T_{configuration} + T_{CP2Q}), contre la tension d'alimentation pour les différentes conceptions de bistable (courbe 80 pour le bistable maître-esclave 100, courbe 82 pour le bistable CMOS, courbe 84 pour le bistable FinFET LSTP et courbe 86 pour le bistable FinFET HP). Une amélioration jusqu'à 23x est obtenue pour le bistable maître-esclave 100 en comparaison aux conceptions à CMOS et FinFET-LSTP.

Le tableau ci-dessous indique le nombre de transistors requis pour le bistable maître-esclave 100 et d'autres bistables de l'art antérieur.

| Architecture de bistable | Total de transistors |
|---|---|
| Bistable TFET 100 | 12 avec le pilote de sortie 106 |
| | 14 avec les pilotes de sortie 106, 146 |
| Grille de transmission (Transmission Gate) | 24 |
| C²MOS (C²MOSFF) | 24 |
| Semi-dynamique (SDFF) | 23 |
| Amp. de détection (SAFF) | 18 ou 19 |
| Amp. de détection modifié (MSAFF) | 26 ou 27 |
| DFF pseudo statique (DFF) | 14 ou 18 |

Le tableau ci-dessus montre que le bistable maître-esclave 100 nécessite moins de transistors que tous les bistables de l'art antérieur.

Une fuite réduite est obtenue avec le bistable maître-esclave 100 en comparaison aux implémentations à CMOS et FinFET en raison d'une fuite ultrabasse du TFET utilisé dans le bistable maître-esclave 100 (I_{OFF} ≈ 10⁻¹⁴ A/µm). Dans le bistable maître-esclave 100, plus de la moitié des TFET sont toujours avec V_{DS} en inverse où une fuite est à son minimum et est indépendante de la V_{GS}. Cela combiné à un dispositif optimisé en termes de fuite se traduit par la consommation d'énergie statique la plus faible parmi toutes les implémentations de l'art antérieur.

L'inverseur à trois états 108, ou l'inverseur à trois états 112, peut être utilisé avec des éléments qui sont différents de ceux correspondant aux éléments du bistable maître-esclave 100. Comme le montre la figure 15, l'inverseur à trois états 108 comprend un circuit de commande 200 fournissant les tensions de commande CLK et CLKN aux premiers TFET 116, 118. Ce circuit de commande 200 peut produire le signal CLKN grâce à l'inverseur 140 divulgué précédemment concernant la figure 6. Le signal appliqué sur l'entrée de l'inverseur à trois états (c'est-à-dire appliqué sur les grilles des premiers TFET 116, 118) est dénommé « ENTREE » et le signal produit en sortie par l'inverseur à trois états 108 (correspondant à celui obtenu sur les drains des premiers TFET 116, 118) est dénommé « SORTIE ».

De même, la bascule D à verrouillage 102, ou la bascule D à verrouillage 104, peut être utilisée avec des éléments qui sont différents de ceux correspondant aux éléments du bistable maître-esclave 100. Comme le montre la figure 16, la bascule D à verrouillage 102 comprend le circuit de commande 200 fournissant les signaux CLK et CLKN aux premiers TFET 116, 118 et aux deuxièmes TFET 120, 122, ainsi que les tensions d'alimentation V_{DD} et V_{SS} aux deuxièmes TFET 120, 122.

La figure 17 représente le bistable maître-esclave 100 comprenant le circuit de commande 200 fournissant les signaux CLK et CLKN et les tensions d'alimentation V_{DD} et Vss aux TFET du bistable 100.

Pour fournir CLK et CLKN, le circuit de commande 200 peut comprendre l'inverseur 140 décrit précédemment concernant la figure 6, le signal CLK correspondant à un signal d'horloge reçu sur une entrée du circuit de commande 200. En variante, il est possible que le circuit de commande comprenne deux inverseurs, chacun étant similaire à l'inverseur 140. Dans ce cas, le signal d'horloge est appliqué sur les grilles des deux TFET du premier inverseur. La sortie du second inverseur (sur lequel CLKN est obtenu) est connectée aux grilles des deux TFET du second inverseur et le signal CLK correspond au signal obtenu sur la sortie du second inverseur.

Les bistables 100 décrits précédemment peuvent comprendre des éléments supplémentaires pour prendre en charge un mode de test et une fonction initialisation/réinitialisation comme dans un bistable classique. Le document US 2015/0039956 A1 divulgue par exemple ces éléments.

Dans la description ci-dessus, les données concernant la fuite, l'aire, l'énergie et la vitesse sont des résultats expérimentaux qui peuvent changer avec un dimensionnement, une implémentation et des technologies différents. De plus, les différentes valeurs d'exemple données pour les différentes tensions peuvent être différentes selon le dimensionnement, l'implémentation et les technologies utilisés.

## Revendications

1. Inverseur à trois états (108,112) comprenant au moins :
- un premier n-TFET (118, 128) et un premier p-TFET (116, 126), le drain du premier n-TFET étant connecté au drain du premier p-TFET et à une sortie de l'inverseur à trois états, les grilles du premier n-TFET et du premier p-TFET étant connectées à une entrée de l'inverseur à trois états ;
- un circuit de commande (200) apte à appliquer une première tension de commande sur la source du premier n-TFET et une seconde tension de commande sur la source du premier p-TFET, les valeurs des première et seconde tensions de commande étant positives ou nulles ;
et dans lequel le circuit de commande est configuré pour commander les valeurs des première et seconde tensions de commande de sorte que, lorsque l'inverseur à trois états est destiné à fonctionner comme un inverseur, la valeur de la première tension de commande est inférieure à la valeur de la seconde tension de commande, et lorsque l'inverseur à trois états est destiné à être dans un état haute impédance, la valeur de la première tension de commande est supérieure à la valeur de la seconde tension de commande se sorte à isoler la sortie de l'inverseur à trois états vis-à-vis de l'entrée de l'inverseur à trois états.

2. Inverseur à trois états (108, 112) selon la revendication 1, dans lequel la première tension de commande est un premier signal d'horloge oscillant entre un état haut et un état bas, et la seconde tension de commande est un second signal d'horloge qui est complémentaire du premier signal d'horloge.

3. Inverseur à trois états (108, 112) selon l'une des revendications précédentes, dans lequel :
- lorsque la valeur de la première tension de commande est supérieure à la valeur de la seconde tension de commande, la valeur de la première tension de commande est comprise entre environ 0,3 V et 0,6 V et la valeur de la seconde tension de commande est égale à environ 0 V, et
- lorsque la valeur de la première tension de commande est inférieure à la valeur de la seconde tension de commande, la valeur de la seconde tension de commande est comprise entre environ 0,3 V et 0,6 V et la valeur de la première tension de commande est égale à environ 0 V.

4. Bascule D à verrouillage (102, 104) comprenant au moins :
- un inverseur à trois états (108, 112) selon l'une des revendications précédentes, l'entrée de l'inverseur à trois états correspondant à une entrée de la bascule D à verrouillage ;
- une bascule à verrouillage (110, 114) comprenant un deuxième n-TFET (122,132), un deuxième p-TFET (120,130) et un noeud de stockage (124,134) formé par la connexion de la source du deuxième n-TFET à la source du deuxième p-TFET, une sortie de la bascule D à verrouillage étant connectée au noeud de stockage de la bascule à verrouillage ;
dans lequel le circuit de commande (200) est apte à appliquer :
- la première tension de commande sur la grille de l'un des deuxièmes n-TFET et p-TFET, et la seconde tension de commande sur la grille de l'autre des deuxièmes n-TFET et p-TFET ;
- une première tension d'alimentation sur la source du deuxième p-TFET et une seconde tension d'alimentation sur la source du deuxième n-TFET ;
et dans lequel les première et seconde tensions d'alimentation sont telles que les deuxièmes n-TFET et p-TFET sont polarisés en inverse dans un état dans lequel un courant de conduction peut être obtenu par un effet de tunnel bande à bande dans les deuxièmes n-TFET et p-TFET.

5. Bascule D à verrouillage (102, 104) selon la revendication 4, dans lequel la différence entre les valeurs des première et seconde tensions d'alimentation est inférieure à environ 0,6 V.

6. Bistable maître-esclave (100) comprenant au moins des première et seconde bascules D à verrouillage (102, 104) selon l'une des revendications 4 et 5, dans lequel :
- la sortie de la première bascule D à verrouillage (102) est connectée à l'entrée de la seconde bascule D à verrouillage (104) ;
- l'entrée de la première bascule D à verrouillage correspond à une entrée du bistable maître-esclave ;
- une sortie du bistable maître-esclave est connectée à la sortie de la seconde bascule D à verrouillage ;
- la valeur de la première tension de commande appliquée dans la première bascule D à verrouillage est égale à la valeur de la seconde tension de commande appliquée dans la seconde bascule D à verrouillage ; et
- la valeur de la seconde tension de commande appliquée dans la première bascule D à verrouillage est égale à la valeur de la première tension de commande appliquée dans la seconde bascule D à verrouillage.

7. Bistable maître-esclave (100) selon la revendication 6, dans lequel :
- la première tension de commande appliquée dans la première bascule D à verrouillage (102) et la seconde tension de commande appliquée dans la seconde bascule D à verrouillage (104) est un premier signal d'horloge oscillant entre un état haut et un état bas ; et
- la seconde tension de commande appliquée dans la première bascule D à verrouillage et la première tension de commande appliquée dans la seconde bascule D à verrouillage est un second signal d'horloge qui est complémentaire du premier signal d'horloge.

8. Bistable maître-esclave (100) selon l'une des revendications 6 et 7, comprenant en outre un premier inverseur (106) comportant au moins un troisième n-TFET (138) et un troisième p-TFET (136), le drain dudit troisième n-TFET étant connecté au drain dudit troisième p-TFET et à une sortie du premier inverseur, les grilles dudit troisième n-TFET et dudit troisième p-TFET étant connectées à une entrée du premier inverseur qui est connectée à la sortie de la seconde bascule D à verrouillage (104),
et dans lequel le circuit de commande (200) est apte à appliquer la première tension d'alimentation sur la source dudit troisième p-TFET et la seconde tension d'alimentation sur la source dudit troisième n-TFET.

9. Bistable maître-esclave (100) selon la revendication 8, comprenant en outre un second inverseur (146) comportant au moins un quatrième n-TFET (150) et un quatrième p-TFET (148), le drain dudit quatrième n-TFET étant connecté au drain dudit quatrième p-TFET et à une sortie du second inverseur, les grilles dudit quatrième n-TFET et dudit quatrième p-TFET étant connectées à une entrée du second inverseur qui est connectée à la sortie du premier inverseur,
et dans lequel le circuit de commande (200) est apte à appliquer la première tension d'alimentation sur la source dudit quatrième p-TFET et la seconde tension d'alimentation sur la source dudit quatrième n-TFET.

10. Bistable maître-esclave (100) selon l'une des revendications 6 à 9, dans lequel, dans chacune des première et seconde bascules D à verrouillage, la première tension de commande est appliquée sur la grille du deuxième n-TFET et la seconde tension de commande est appliquée sur la grille du deuxième p-TFET.

11. Bistable maître-esclave (100) selon l'une des revendications 6 à 9, dans lequel, dans chacune des première et seconde bascules D à verrouillage, la première tension de commande est appliquée sur la grille du deuxième p-TFET et la seconde tension de commande est appliquée sur la grille du deuxième n-TFET.
